# EUROPÄISCHE PATENTANMELDUNG

(11) **EP 0 822 661 A2**
(43) Veröffentlichungstag der Anmeldung: **04.02.1998**
(21) Anmeldenummer: 97112737.8
(22) Anmeldetag: 24.07.1997
(51) Int. Cl.: H03K 17/082

(54) **Ansteuerschaltung für ein Feldeffekt gesteuertes Leistungs-Halbleiterbauelement**

(30) Priorität: 02.08.1996 DE 19631362
(71) Anmelder: SIEMENS AKTIENGESELLSCHAFT, 80333 München (DE)
(72) Erfinder: Tihanyi, Jenö, Dr., 85551 Kirchheim (DE)

(57) **Zusammenfassung**

Die erfindungsgemäße Ansteuerschaltung für ein Feldeffekt gesteuertes Leistungs-Halbleiterbauelement weist einen steuerbaren Gatewiderstand für das Leistungs-Halbleiterbauelement auf, welcher im Normalfall niederohmig und im Kurzschlußfall hochohmig geschaltet wird. Dadurch wird die Einschaltzeit im Normalfall verkürzt und die Begrenzung der Gate-Sourcespannung des Leistungs-Halbleiterbauelements im Kurzschlußfall ermöglicht.

## Beschreibung

Die Erfindung betrifft eine Ansteuerschaltung für ein Feldeffekt gesteuertes Leistungs-Halbleiterbauelement gemäß dem Oberbegriff des Anspruchs 1.

Eine derartige Ansteuerschaltung ist z.B. aus der DE 42 05 753 bekannt. Darin ist gemäß Figur 1 ein MOSFET 1 beschrieben, dessen Gate über einen Widerstand 6 mit einem Steuereingang verbunden ist. Zwischen Gate und Source des Leistungs-Halbleiters 1 ist die Laststrecke eines MOSFET geschaltet, der in Abhängigkeit von der Drain-Sourcespannung des Leistungs-Halbleiters 1 angesteuert wird. Eine derartige Schaltungsanordnung wird bei Leistungs-Halbleiterbauelementen mit MOS-Eingang dazu verwendet, den Strom I_{DS} im Kurzschlußfall zu begrenzen. Eine derartige Zusatzschaltung beinhaltet grundsätzlich einen Serienwiderstand, im vorliegenden Fall Widerstand 6, welcher erforderlich ist, um die Strombegrenzung zu gewährleisten.

Nachteil einer derartigen Anordnung ist, daß die Einschaltgeschwindigkeit durch den seriellen Widerstand begrenzt wird und dadurch relativ lang wird.

Eine weitere gattungsgemäße Schaltungsanordnung ist aus der US 5 506 539 bekannt. Die insbesondere in Figur 3 angegebene Schaltungsanordnung weist eine Schutzschaltung auf, die einen steuerbaren Widerstand in den hochohmigen und niederohmigen Zustand schaltet. Die dort angegebene Schaltungsanordnung ist allerdings äußerst aufwendig und kompliziert zu realisieren.

Ausgehend von diesem Stand der Technik ist es daher die Aufgabe der vorliegenden Erfindung, eine einfache Ansteuerschaltung für ein Feldeffekt gesteuertes Halbleiterbauelement mit einer Schutzschaltung anzugeben, bei der die Einschaltzeit verkürzt wird und die sich auf einfache Weise durch die Verwendung von wenigen Bauelementen realisieren läßt.

Diese Aufgabe wird durch den kennzeichnenden Teil des Anspruchs 1 gelöst. Weiterbildungen sind Kennzeichen der Unteransprüche.

Prinzip der Erfindung ist es, daß ein Durchlaß-MOSFET eingesetzt wird, welcher in Abhängigkeit vom Zustand der Schutzschaltung (aktiv oder deaktiv), hochohmig oder niederohmig geschaltet wird. Hierbei wird bei der ersten Einschaltflanke eines Eingangssignals die Gate-Source-Kapazität des Durchlaß-MOSFET aufgeladen. Die Gate-Source-Kapazität bleibt so lange aufgeladen, bis sie durch ein Steuersignal der Schutzschaltung, beispielsweise bei einer Übertemperatur oder eines Kurzschlusses entladen wird. In diesem sogenannten Notfallbetrieb wird der Durchlaß-MOSFET ausgeschaltet. Dadurch kann die Gate-Source-Spannung am Leistungs-Halbleiterbauelement über ein geeignetes Schaltmittel reduziert werden und somit der Kurzschlußstrom begrenzt wird.

Eine besonders einfache und vorteilhafte Realisierung ergibt sich, wenn der Ansteuerwiderstand für den Durchlaß-MOSFET als Schaltdiode, die in Flußrichtung das Gate des Durchlaß-MOSFET ansteuert, realisiert ist. Besonders vorteilhaft ist es, wenn diese Schaltdiode als MOS-Diode ausgebildet ist.

Die Erfindung wird nachfolgend anhand von drei Figuren näher erläutert.

Es zeigt:
- Figur 1: ein erstes Ausführungsbeispiel einer erfindungsgemäßen Anordnung,
- Figur 2: ein zweites Ausführungsbeispiel der erfindungsgemäßen Anordnung, bei der nur die relevanten Schaltelemente dargestellt sind, und
- Figur 3: den zeitlichen Verlauf des an der Eingangsklemme 1 anliegenden Steuersignals sowie der Gate-Sourcespannung mit und ohne der erfindungsgemäßen Anordnung.

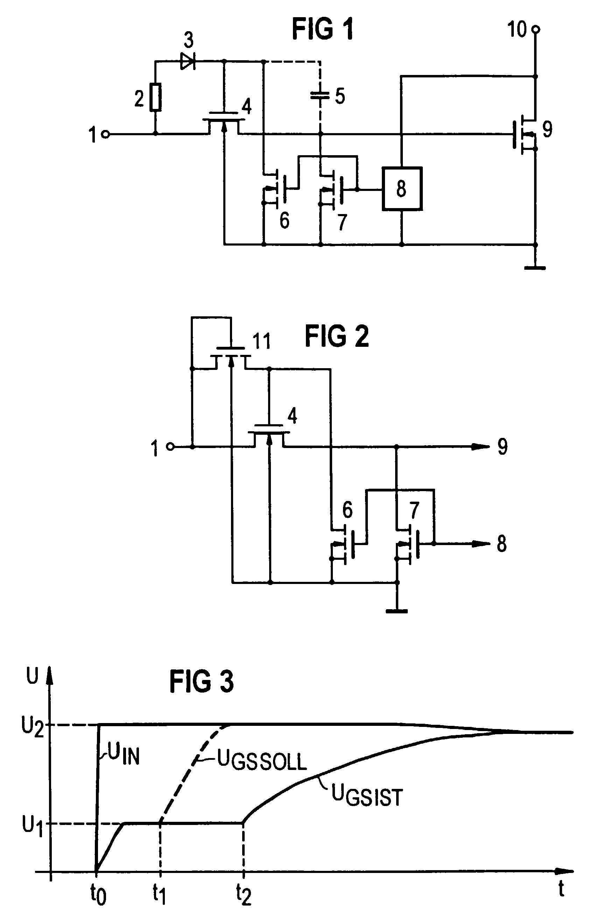

In Figur 1 ist mit 1 eine Eingangsklemme bezeichnet, an welche ein Ansteuersignal anlegbar ist. Diese Klemme ist über die Laststrecke eines Durchlaß-MOSFET 4 mit dem Gate eines Leistungs-MOSFET 9 verbunden. Des weiteren ist die Eingangsklemme 1 über einen Widerstand 2 und eine in Flußrichtung geschaltete Diode 3 mit dem Gate des Durchlaß-MOSFET 4 verschaltet. Das Gate des Durchlaß-MOSFET 4 ist über die Laststrecke eines ersten MOSFET 6 mit Masse verbunden. Der Substratanschluß des Durchlaß-MOSFET 4 ist ebenso mit Masse verschaltet.

Zwischen dem Katodenanschluß der Diode 3 und dem Gateanschluß des Leistungs-MOSFET 9 ist gestrichelt eingezeichnet die Gate-Source-Kapazität 5 des Durchlaß-MOSFET 4 dargestellt. Zwischen dem Drain- und Sourceanschluß des Leistungs-MOSFET 9 ist eine Schutzschaltung 8 vorgesehen, die die Spannung zwischen Drain und Source abgreift. Im Notfall, beispielsweise bei einer Übertemperatur, einer Überspannung, einem Kurzschluß, oder ähnlichem, erzeugt die Schutzschaltung 8 an ihrem Ausgang ein Steuersignal, das einerseits dem Gate des ersten MOSFET 6 sowie andererseits dem Gate eines zweiten MOSFET 7 zugeführt wird. Im vorliegenden Fall handelt es sich bei den beiden MOSFETs 6, 7 um Enhancement-MOSFET, die durch dieses Steuersignal leitend geschalten werden können. Die Gatekapazitäten der MOSFET 4 und 9 werden gleichzeitig entladen. Die Laststrecke des zweiten MOSFET 7 ist zwischen Gateanschluß des Leistungs-MOSFET 9 und Masse geschaltet. Im vorliegenden Ausführungsbeispiel ist der Leistungs-MOSFET 9 ein Low-Side-Schalter, dessen Drainanschluß mit einer Anschlußklemme 10 und dessen Sourceanschluß mit Masse verbunden ist. Es wäre jedoch auch denkbar den Leistungs-MOSFET 9 als High-Side-Schalter auszuführen.

Im Normalbetrieb wird durch ein positives Ansteuersignal bei der Einschaltflanke an der Eingangsklemme 1 die Gate-Source-Kapazität 5 des Durchlaß-MOSFET 4 durch die Diode 3 auf eben diese Ansteuerspannung aufgeladen und steuert somit den Durchlaß-MOSFET 4 niederohmig. So lange die Schaltung im Normalbetrieb arbeitet und kein Überstrom vorliegt, bleibt dieser Zustand, daß heißt die Ladung auf dem Gate des DurchlaßMOSFETs 4, erhalten.

Im sogenannten Notfallbetrieb, beispielsweise bei einem Kurzschluß, bei Überspannung, bei Übertemperatur, oder ähnlichem, wird die Schutzschaltung 8 aktiviert und steuert sowohl den ersten MOSFET 6 als auch den zweiten MOSFET 7 an. Dadurch wird der MOSFET 6 leitend geschaltet und entlädt die Gatekapazität 5 des MOSFET 4. Durch diese Maßnahme erhöht sich der Widerstand der Laststrecke des MOSFET 4 und die Strombegrenzung des Leistungs-MOSFET 9 wird nun dadurch aktiviert, daß der zweite MOSFET 7 leitend geschaltet wird und die Gate-Sourcespannung des Leistungs-MOSFET 9 verringert.

Figur 2 zeigt ein Ausführungsbeispiel für den Widerstand 2 und die Diode 3 gemäß Figur 1. Alle übrigen Bauelemente entsprechen denen gemäß Figur 1, wobei die Elemente 8, 9 und 10 der Übersichtlichkeit halber in Figur 2 nicht dargestellt sind.

Der Widerstand 2 und die Diode 3 werden gemäß Figur 2 durch einen Enhancement-MOSFET 11 realisiert. Dessen Laststrecke ist zwischen Eingangsklemme 1 und Gateanschluß des Durchlaß-MOSFET 4 geschaltet. Der Gateanschluß des MOSFET 11 ist ebenfalls mit der Eingangsklenme 1 verbunden. Der Substratanschluß des MOSFET 11 ist mit Masse verschaltet.

Figur 3 zeigt den zeitlichen Verlauf des an der Eingangsklemme 1 anliegenden Steuersignals sowie der Gate-Sourcespannung am Leistungs-MOSFET 9 jeweils mit und ohne der erfindungsgemäßen Schaltungsanordnung.

Zum Zeitpunkt tₒ wird das Ansteuersignal U_{IN} an die Eingangsklemme 1 angelegt. Bei einer Schaltungsanordnung gemäß des Standes der Technik ist der Verlauf der Gate-Source-Spannung am Leistungs-MOSFET 9 durch den Verlauf der Kurve U_{GSIST} dargestellt. Die Spannung steigt zuerst auf einen mittleren Wert U₁ an und beginnt zum Zeitpunkt t₂ sich zunächst mit einem arctan-ähnlichen Verlauf der Spannung U₂, welche im wesentlichen der Eingangsspannung U_{IN} entspricht, asymptotisch zu nähern.

U_{GSSOLL} stellt den Verlauf der Gate-Sourcespannung am Leistungs-MOSFET 9 beim Einsatz einer erfindungsgemäßen Anordnung dar. Im Gegensatz zum bisherigen Verlauf steigt nun die Gate-Sourcespannung am Leistungs-MOSFET 9 bereits zu einem Zeitpunkt t₁, der zwischen dem Zeitpunkt t₀ und dem Zeitpunkt t₂ liegt, rasch an und nähert sich erheblich früher dem eigentlichen Endwert U₂.

Die Erfindung ist sowohl bei Low-Side-Schaltern, gemäß Figur 1 bzw. Figur 2, wie auch bei High-Side-Schaltern anwendbar. Wesentlich ist, daß durch die Erfindung erreicht wird, daß der Gatewiderstand des Leistungs-MOSFET 9, d.h. die Laststrecke des Durchlaß-MOSFET 4, im Normalbetrieb klein und im Notfallbetrieb groß ist. Die Erfindung kann in allen bekannten Technologien in integrierter Form als auch diskret ausgeführt werden.

Gegenüber dem Stand der Technik erweist sich die vorliegende Erfindung in der Weise als vorteilhaft, daß sie sehr viel weniger Bauelemente zur erfindungsgemäßen Realisierung der Schaltungsanordnung benötigt. Des weiteren lassen sich durch die vorliegende Erfindung die beiden MOSFET 6, 7, die zur Entladung der Gate-Source-Kapazität des Durchlaß-MOSFET 4 bestimmt sind, sehr klein realisieren.

## Patentansprüche

1. Ansteuerschaltung für ein durch Feldeffekt gesteuertes Leistungs-Halbleiterbauelement (9) mit einem Durchlaß-MOSFET (4), über den ein Ansteuersignal (1) dem Gateanschluß des Leistungs-Halbleiterbauelements (9) zuführbar ist, falls der Durchlaß-MOSFET (4) leitet,
**dadurch gekennzeichnet,**
daß die Gate-Source-Kapazität (5) des Durchlaß-MOSFET (4) beim Einschalten aufgeladen wird und dadurch den MOSFET (9) leitend schaltet, und daß die Gate-Source-Kapazität (5) des Durchlaß-MOSFET (4) so lange aufgeladen bleibt, bis im Notfallbetrieb eine Schutzschaltung (8) ein Steuersignal erzeugt, welches den Durchlaß-MOSFET (4) sperrt.

2. Ansteuerschaltung nach Anspruch 1,
**dadurch gekennzeichnet,**
daß das Aufladen der Gate-Sourcekapazität (5) des Durchlaß-MOSFET (4) bei der ersten positiven Einschaltflanke des Eingangssignals (1) erfolgt.

3. Ansteuerschaltung nach einem der vorhergehenden Ansprüche,
**dadurch gekennzeichnet,**
daß im Notfallbetrieb das Aufladen der Gate-Sourcekapazität (5) des Durchlaß-MOSFET (4) und das Schalten des Leistungs-Halbleiterbauelements (9) gleichzeitig erfolgt.

4. Ansteuerschaltung nach einem der vorhergehenden Ansprüche,
**dadurch gekennzeichnet,**
daß zwischen dem Gateanschluß des Durchlaß-MOSFET (4) und Masse die Laststrecke eines Enhancement-MOSFET (6) geschaltet ist, der im Notfallbetrieb durch die Schutzschaltung (8) angesteuert wird.

5. Ansteuerschaltung nach einem der vorhergehenden Ansprüche,
**dadurch gekennzeichnet,**
daß der Durchlaß-MOSFET (4) ein Depletion-MOSFET ist.

6. Ansteuerschaltung nach einem der vorhergehenden Ansprüche,
**dadurch gekennzeichnet,**
daß die Aufladung der Gate-Sourcekapazität (S) des Durchlaß-MOSFET (4) durch einen Diodenwiderstand (2, 3) erfolgt.

7. Ansteuerschaltung nach Anspruch 6,
**dadurch gekennzeichnet,**
daß der Diodenwiderstand (2, 3) eine MOS-Diode (11) ist.
